# EUROPEAN PATENT SPECIFICATION

(11) **EP 0 429 270 B1**
(45) Date of publication and mention of the grant of the patent: **21.08.1996**
(21) Application number: 90312550.8
(22) Date of filing: 19.11.1990
(51) Int. Cl.: G03F 7/36

(54) **Continuous etching method and apparatus therefor**
Verfahren und Vorrichtung zum kontinuierlichen Ätzen
Méthode et appareil pour la gravure en continu

(30) Priority: 20.11.1989 JP 301618/89
(43) Date of publication of application: 29.05.1991
(73) Proprietor: KOKUSAI ELECTRIC CO., LTD., Tokyo-to (JP)
(72) Inventor: Okudaira, Sadayuki, Ome-shi, Tokyo-to (JP); Komatsu, Hideo, Nishitama-gun, Tokyo-to (JP); Matsumoto, Osamu, Akishima-shi, Tokyo-to (JP); Kanazawa, Motoichi, Nishitama-gun, Tokyo-to (JP); Sasada, Kazuo, Akishima-shi, Tokyo-to (JP); Naito, Tsuyoshi, Akigawa-shi, Tokyo-to (JP)
(74) Representative: Hale, Peter

(56) References cited:
- EP-A- 0 027 929
- EP-A- 0 333 591
- WO-A-89/07285
- DD-A- 267 515

## Description

The present invention relates to a continuous etching method comprising the steps of: forming a multilayer resist membrane on a member to be etched; patterning the top resist layer by means of, for example, light, X-ray or electronic line drawing; conveying the member to a first treatment region; introducing a gas to the first treatment region and generating a discharge plasma; dry-etching the multilayer resist; conveying the member to a second treatment region; dry-etching the member to a predetermined depth in the second treatment region; conveying the member to a third treatment region; removing the resist according to the patterning and plasma treatment in the third treatment region; and conveying the member between the treatment regions in an evacuated environment. A process substantially of this kind is disclosed in WO 89/07285.

The invention is particularly applicable to wafer dry etching steps in a semiconductor manufacturing process, including, for example, a dry etching step for etching a mask, a dry etching step for etching the wafer, and subsequent after-treatment.

According to the conventional dry etching process, a resist pattern or a mask used in the process has been created in an extra or different process and apparatus to that used for the wafer dry etching process itself. Ordinarily, a resist material is exposed to light and then a solution is used to carry out a development treatment. Nowadays, the depth of the resist pattern to be treated or generated is around 0.5 µm, so that it becomes difficult to make a pattern of photo-resist by the conventional development method using a unilayer resist. Recently, in order to overcome the difficulty of the conventional development method, the resist has been made from a multilayer membrane. The top layer membrane is made flat, and the bottom layer of the resist must be vertically treated by oxygen plasma.

Concerning this so-called oxygen plasma method, it is desirable to treat or machine the resists by using low gas pressure with high accuracy in the notionally vertical direction and minimal horizontal shift.

However, practically speaking it is very difficult to reduce the amount of shift below about 0.1 um. Consequently, it is not practical to depend only on the oxygen plasma method and it is necessary to employ a side wall protective membrane forming process, as previously used in dry etching, in resist treatment. Such resist treatment requires the use of gases including chlorine.

Thus, various dry etching processes have been carried out individually using separate treatment appliances or separate treatment units.

After treatment the wafers are transferred in the atmosphere. However, when the wafer is exposed to the atmosphere after treatment, in particular resist treatment with a gas containing chlorine, a base material to be etched is apt to corrode. As a result the dimensional precision after treatment is adversely affected or the desired precision is not achieved.

The reason for this corrosion seems to be that the halogen element, such as chlorine, remains on the top surface of the wafers and reacts with water in the atmosphere, generating acid. The acid then reacts with the etched material. The reactions are local cell effects, so that the material corrodes very quickly.

An object of the present invention is to provide an etching process and apparatus preventing the wafer from corroding and also to allow the manufacture of wafers with a high yield.

The present invention is characterised by heat treating the member simultaneously with removal of the resist in the third treatment region and plasma treating the member so as to form a protective cover.

The invention also extends to continuous etching apparatus comprising a vacuum conveying chamber, a load unit communicable with the vacuum conveying chamber through a first air-tight gate, an unload unit communicable with the vacuum conveying chamber through a second air-tight gate, a resist etching unit communicable with the vacuum conveying chamber through a third air-tight gate, and a further etching unit communicable with the vacuum conveying chamber through a fourth air-tight gate, an after-treatment unit communicable with the vacuum conveying chamber through a fifth air-tight gate, and conveying means in the vacuum conveying chamber arranged to convey articles between respective units, characterised in that the after treatment unit comprises heating means, the unit being operable to heat and plasma treat the member simultaneously with removal of the resist so as to form a protective cover.

These and other preferable features are defined in the accompanying claims.

The present invention can be put into practice in various ways some of which will now be described with reference to the accompanying drawings, in which :-
Fig.1 is a plan view of an embodiment of continuous etching apparatus according to the invention;
Fig.2 is a plan view of another embodiment;
Fig.3 is a similar view of still another embodiment; and
Fig.4 shows a section through a wafer.

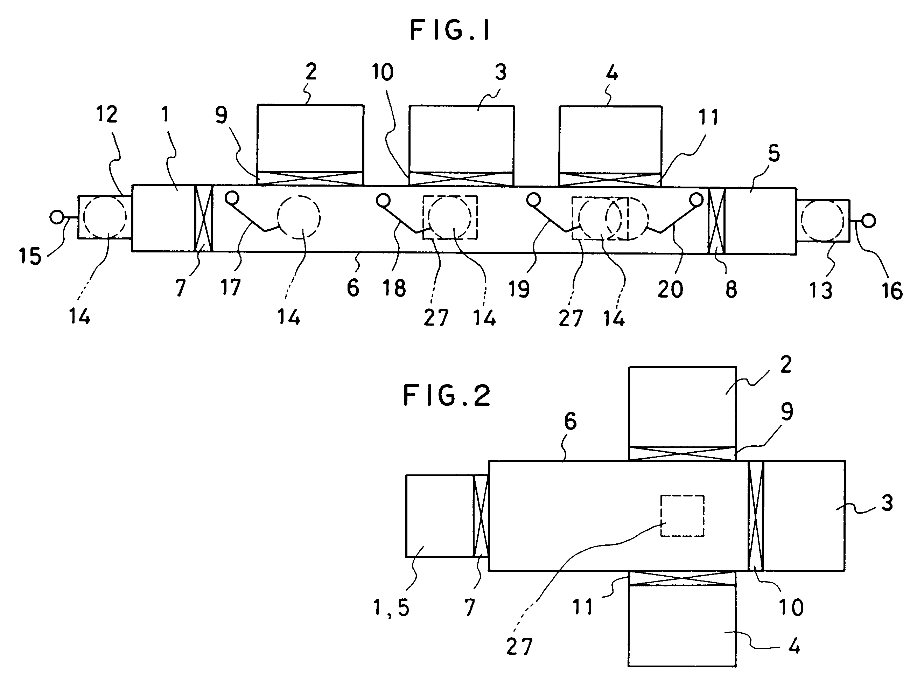

The apparatus shown in Fig.1 consists of six units contained mainly within a pressure-reduced vessel.

The apparatus has a load unit 1, a resist etching unit 2, a plasma etching unit 3, an after-treatment unit 4, and an unload unit 5. The load unit 1 receives members to be treated (wafers) in the atmosphere. The resist etching unit 2 for etching resist layers on the wafer has wafer temperature control means and an ion energy controller for generating plasma at a gas pressure of 1 mTorr. The plasma etching unit 3 for treating the material to be etched by a plasma etching process has wafer temperature control means (cooling means and/or heating means). The after-treatment unit 4 has heating means so as to carry out corrosion prevention treatment on the wafer by plasma or other source of heat located in a treatment table. The unload unit 5 unloads the treated wafers.

It will be noted that the load unit 1 and the unload unit 5 are air-tightly connected and placed at an upstream end and a downstream end, respectively, of an elongate vacuum conveying chamber 6 communicating through gate valves 7 and 8. The resist etching unit 2, the plasma etching 3 and the after-treatment unit 4 are air-tightly connected to a side face of the elongate vacuum conveying chamber 6 through gate valves 9, 10, and 11. Thus, the units 2, 3 and 4 can be isolated from one another and the conveying chamber 6 can isolate these units from the atmosphere.

The load unit 1 has a first cassette receiving stand 12 connected thereto and the unload unit 5 has a second cassette receiving stand 13 connected thereto. The first cassette receiving stand 12 has a transfer device 15 for transferring wafers 14 to the load unit 1, and the second stand 13 also has a transfer device 16 for taking the wafers out of the unload unit 5 and transferring them to a cassette (not shown) on the second stand 13.

In the vacuum chamber 6, there are: a first conveying unit 17, for conveying wafers 14 from the unload unit 5 to the resist etching unit 2; a second conveying unit 18, for conveying the wafers 14 between the resist etching unit 2 and the plasma etching unit 3; a third conveying unit 19, for conveying the wafers 14 between the plasma etching unit 3 and the after-treatment unit 4; and a fourth conveying unit 20, for conveying the wafers 14 between the unload unit 5 and the plasma etching unit 3.

The etching treatment procedure is as follows :

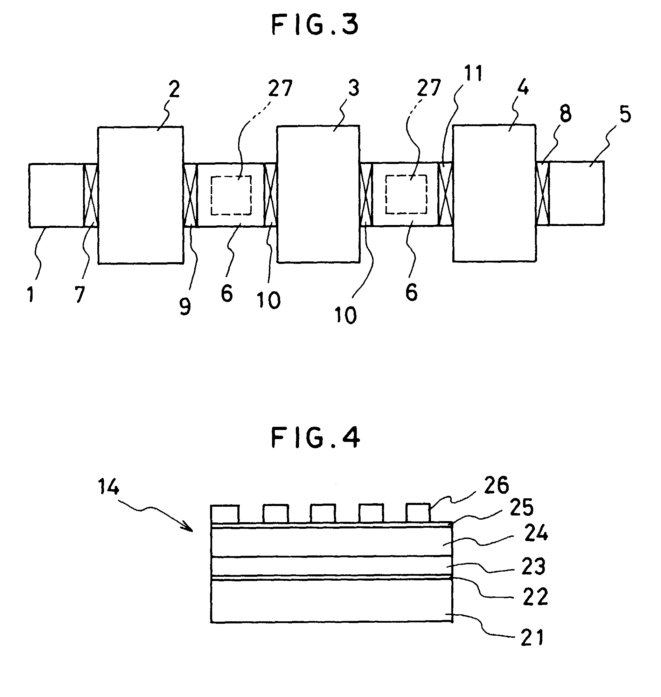

First, the wafers 14 to be treated in the continuous etching apparatus are constructed as shown in Fig.4. Each wafer consists of a silicon substrate 21, an oxidized membrane 22 on the substrate, an A1-0.5%Cu-Si membrane 23 of a thickness of about 1µm on the membrane 22, a photoresist layer 24 of a thickness of about 1.5 µm on the membrane 23, a glass membrane 25 of about 0.1 µm of spin on glass (SOG) liquid applied to the photoresist, and the top layer of a photoresist mask 26 having a pattern formed by light, laser, X-rays or electron beam. The photoresist layer 24 is heat-treated at a temperature of 200°C.

The cassette storing the wafer 14 is as shown placed on the first cassette receiving stand 12. The wafer is then transferred from the cassette to the load unit 1 by means of the transfer device 15. According to this embodiment of the present invention, a suitable surface material of the wafer 14 is A1-Cu-Si.

The gate valve 7 is opened and the first conveying unit 17 takes the wafer 14 into the vacuum conveying chamber 6. During this time, the gate valves 9, 10 and 11, respectively, are kept closed.

When the gate valve 7 is closed, the vacuum conveying chamber 6 is evacuated. The wafer 14 is then conveyed to the resist etching unit 2 through the opened gate valve 9. Closing the gate valve 9, the gas mixture of oxygen and chlorine is supplied to the resist etching unit 2. Plasma is generated in the unit and the resist is etched while cooling the wafer 14. The time to complete the etching treatment is known or indicated by a light, luminous monitor or the like, connected to equipment monitoring the condition of the plasma.

After completion of the etching, the interior of the resist etching unit 2 is evacuated, the gate valve 9 opens, the first conveying unit 17 takes the wafer 14 out of the unit 2, and finally the gate valve 9 shuts. Next, the gate valve 10 of the plasma etching unit 3 opens and the etched wafer 14 is conveyed to the etching unit 3 by means of the second conveying unit 18. The gate valve 10 opens to allow the wafer in and is then shut. A plurality of chlorinous gases are supplied to the plasma etching unit 3 and plasma etching is carried out on the wafer 14 which is cooling during plasma etching. Again, the time of completion of plasma etching is indicated by a luminous monitor or the like. After completion of the etching treatment, the plasma etching unit 3 is evacuated, the gate valve 10 opens, the second conveying unit 18 takes the etched wafer 14 out of the unit 3, and finally the gate valve 10 shuts. Next, the gate valve 11 of the after-treatment unit 4 opens and the third conveying unit 19 conveys the etched wafer 14 to the after-treatment unit 4.

In the after-treatment unit 4, a treatment, mainly of O₂ plasma and heat treatment at about 200^{o}C, removes the resist from the wafer. The after-treatment also applies a protective membrane. This protective membrane Is preferably of a kind which is easily-removed from the inner wall of the after-treatment unit 4 during etching or removing the next resist, because the protective membrane also tends to coat that inner wall. It is also preferable to use a hydrocarbon-based gas including some hydrogen atoms as a reaction gas used in the after-treatment.

After completion of the after-treatment, the interior of the after-treatment unit 4 is evacuated, the gate valve 11 opens, the third conveying unit 19 takes the wafer 14 out of the unit 19, and the gate valve 11 shots. After ensuring that the gate valves 9, 10, and 11 are shut, the gate valve 8 opens to convey the treated wafer 14 to the unload unit 5 by the fourth conveying unit 20. The wafer 14 in the unload unit 5 is transferred to the cassette on the second cassette receiving stand 13 by the second transfer device 16.

When the treatment times of the resist etching, the plasma etching, and the after-treatment are different and the wafer proceeds through such steps sequentially, wafer waiting units 27 are used to queue the wafers 14 in order to diminish the time lag before treatment in the units.

Opening of the gate valves 7 and 8 placed at the upstream and downstream ends of the vacuum conveying chamber 6 is effected when the wafers 14 are loaded in respective units 2, 3 and 4. When the wafer 14 waits on the wafer waiting unit 27, no opening and closing of the gate valves 7 and 8 takes place in order to prevent the wafer 14 from becoming exposed to the atmosphere before completion of the series of the treatments.

It is of course possible to keep the gate valves 7 and 8 open, if the cassette receiving stand is arranged to place the wafer directly in the pressure-reduced vessel containing the load unit 1, the resist etching unit 2, the plasma etching unit 3, the after-treatment unit 4, the unload unit 5, and the vacuum conveying chamber 6 and the series of treatments are completed on each cassette before the next is loaded. This improves throughput of the continuous etching apparatus according to the present invention.

No corrosion is observed on the wafers if they are exposed to the atmosphere for 24 (twenty four) hours after being continuously treated by the etching method of the present invention and taken out of the unload unit 5.

Although the material to be etched in the embodiment above is A1-Cu-Si, it is possible to achieve corresponding effects when, for example, Si, Poly Si, WSi₂ are used.

Also, the material to be etched in the embodiment above is a unilayer of A1-Cu-Si, but when the unilayer has a second layer membrane of TiW or W, an etching effect is apt to be insufficient if any etching is achieved at all, when using only a chlorinous gas mixture. This is because the etch speed of TiW and W is very slow in chlorinous gas. Consequently, it is preferable to etch such material in fluorine. However, A1-Cu-Si is not etched by fluorinous gas. It has been found that, when after A1-Cu-Si is etched in a gas mixture containing chlorine in a treatment chamber, the gas is replaced by a fluorinous gas which etches the TiW or W, the amount of dust produced increases. Under these circumstances, when any combination of individual materials of a wafer respectively necessitate chlorinous gas and fluorinous gas atmospheres, two treatment chambers are preferable. Each material is treated in the particular chamber, thus decreasing total amount of dust to which the wafer is exposed at any time.

When A1-Cu-Si is etched in an individual chamber, the material is preferably heated to about 80^{o}C before etching. W is preferably etched in an atmosphere at about -50^{o}C. In both cases, the features of etched and finished shapes, etching speeds, and selection ratios are excellent. When the material to be etched is Si or Poly Si, it is preferable to cool it to about -130^{o}C.

The wafers 14 are cooled in the resist etching step and the plasma etching step by various systems of liquified nitrogen and a controllable heater or by various refrigerator and controllable heater systems. The former system is suitable for a heating range from -150^{o}C to -80^{o}C. The latter system is preferable for a temperature from -80°C to 0°C. In the after-treatment step of the process, heating means, rather than cooling means, are required. It is preferable to have control in the range from room temperature to about 250^{o}C.

According to the embodiment of the present invention, in which the etching is carried out after the material is cooled, the absorption efficiency of the gases will become high, so that it is permitted to lower the flow rate and partial pressure of, in particular, a deposition gas. In practice, it is possible to carry out precise etching without dimensional shifts with only oxygen plasma when no chlorinous gas is blended with the oxygen and the temperature of the material or wafers is maintained at -100^{o}C.

Because the treatment effect of etching according to the present invention does not decrease even the flow rate or pressure of the deposition gas, the amount of dirt becoming stuck on the walls of the vacuum or pressure-reduced vessel is considerably reduced and a cleaner system of semiconductor manufacture and apparatus therefor can be realised. It is of course the case that the effective temperature of the wafer depends on the kind of deposition gas used.

Fig.2 shows another arrangement of various units of a continuous etching apparatus according to the present invention. As shown, the resist etching unit 2, the plasma etching unit 3, and the after-treatment unit 4 are placed around the vacuum conveying chamber 6.

Fig.3 shows still another arrangement, in which the various treatment units 2, 3 and 4 are connected through two vacuum chambers 6.

It will be appreciated that the same parts and features of the apparatus, respectively shown in Figs. 1, 2 and 3 have the same reference numerals.

According to the present invention, a series of etching treatments to be carried on the material to be etched are done in a vacuum without exposure to the atmosphere, so that no corrosion is experienced by the wafer. This results in improved etching and machining precision and improved yields of the product. Compared with the conventional after-treatment for preventing the wafer from corroding in the atmosphere, the unique corrosion prevention method of the present invention, which employs a protective membrane finally applied on the top of the wafer, necessitates the least number of deposition membranes. The membrane used is easily removed just before the step following its application. Owing to the effect of the continuous vacuum treatment of the present invention, it is possible to decrease considerably the dirt on the wafer and dust generation in the environment, leading to high reliability components made from wafers so etched.

## Claims

1. A continuous etching method comprising the steps of:
forming a multilayer resist membrane on a member to be etched;
patterning the top resist layer by means of, for example, light, X-ray or electronic line drawing;
conveying the member to a first treatment region (2);
introducing a gas to the first treatment region and generating a discharge plasma;
dry-etching the multilayer resist;
conveying the member to a second treatment region (3);
dry-etching the member to a predetermined depth in the second treatment region;
conveying the member to a third treatment region (4) ;
removing the resist according to the patterning and plasma treatment in the third treatment region; and
conveying the member between the treatment regions (2, 3, 4) in an evacuated environment (6); characterised by:
heat treating the member simultaneously with removal of the resist in the third treatment region and plasma treating the member so as to form a protective cover.

2. A method as claimed in claim 1, wherein the member to be etched consists of a plurality of layers and, when respective layers cannot be etched in the same gaseous environment, performing each etching step in an individual treatment region.

3. A method as claimed in claim 2, wherein the respective gaseous environments of the individual treatment regions are fluorinous and chlorinous.

4. A method as claimed in claim 1, wherein the reaction gas for generating the protective cover is hydrocarbon-based.

5. Continuous etching apparatus comprising a vacuum conveying chamber (6), a load unit (1) communicable with the vacuum conveying chamber through a first air-tight gate (7), an unload unit (5) communicable with the vacuum conveying chamber through a second air-tight gate (8), a resist etching unit (2) communicable with the vacuum conveying chamber through a third air-tight gate (9), and a further etching unit (3) communicable with the vacuum conveying chamber through a fourth air-tight gate (10), an after-treatment unit (4) communicable with the vacuum conveying chamber through a fifth air-tight gate (11), and conveying means (17,18,19,20) in the vacuum conveying chamber arranged to convey articles between respective units, characterised in that the after-treatment unit (4) comprises heating means, the unit being operable to heat and plasma treat the member simultaneously with removal of the resist so as to form a protective cover.

6. Apparatus as claimed in claim 5, wherein the resist etching unit (2) and the further etching unit (3), each comprise cooling means.

7. Apparatus as claimed in claim 6, wherein the cooling means comprise a liquified nitrogen-based cooler and a heater.

8. Apparatus as claimed in claim 6, wherein the cooling means comprises a refrigerator and a heater.

9. Apparatus as claimed in any of claims 5 to 8, further comprising a waiting unit (27) in the vacuum conveying chamber (6) in which members to be etched can be queued during conveyance between units.

## Patentansprüche

1. Verfahren zum kontinuierlichen Ätzen, welches folgende Schritte umfaßt: Ausbildung einer mehrschichtigen Abdeckung auf einem zu ätzenden Teil; Versehen der obersten Abdeckschicht mit einem Muster, z. B. mittels Licht-, Röntgen- oder Elektronenstrahlzeichnen; Transport des Teiles zu einem ersten Bearbeitungsbereich (2); Zuführung eines Gases zum ersten Bearbeitungsbereich und Erzeugung eines Ätzplasmas; Trockenätzung der mehrschichtigen Abdeckung; Transport des Teiles zu einem zweiten Bearbeitungsbereich (3); Trockenätzung des Teiles in dem zweiten Bearbeitungsbereich bis zu einer vorbestimmten Tiefe; Transport des Teiles zu einem dritten Bearbeitungsbereich (4); Entfernung der Abdeckung gemäß dem Muster und Bearbeitung mittels eines Plasmas im dritten Bearbeitungsbereich; und Transport des Teiles zwischen den Bearbeitungsbereichen (2, 3, 4) im Vakuum (6); **gekennzeichnet durch** eine Wärmebehandlung des Teiles simultan zur Entfernung der Abdeckung im dritten Bearbeitungsbereich sowie eine Plasmabehandlung des Teiles, so daß eine Schutzschicht gebildet wird.

2. Verfahren nach Anspruch 1, **dadurch gekennzeichnet**, daß das zu ätzende Teil eine Vielzahl von Schichten aufweist, und daß, wenn die verschiedenen Schichten nicht in derselben Gasatmosphäre geätzt werden können, jeder Ätzungs-Schritt in einem individuellen Bearbeitungsbereich durchgeführt wird.

3. Verfahren nach Anspruch 2, **dadurch gekennzeichnet**, daß die verschiedenen Gasatmosphären der einzelnen Bearbeitungsbereiche Fluor und Chlor umfassen.

4. Verfahren nach Anspruch 1, **dadurch gekennzeichnet**, daß das Reaktionsgas zur Erzeugung der Schutzschicht auf Kohlenwasserstoff basiert.

5. Vorrichtung zum kontinuierlichen Ätzen, umfassend eine Vakuum-Transportkammer (6), eine Einlaßeinrichtung (1), die mit der vakuum-Transportkammer über einen ersten hermetischen Durchlaß (7) in Verbindung steht, eine Auslaßeinrichtung (5), die mit der vakuum-Transportkammer über einen zweiten hermetischen Durchlaß (8) in Verbindung steht, eine Ätzeinrichtung (2) für die Abdeckung, die mit der vakuum-Transportkammer über einen dritten hermetischen Durchlaß (9) in Verbindung steht, und eine weitere Ätzeinrichtung (3), die mit der vakuum-Transportkammer über einen vierten hermetischen Durchlaß (10) in Verbindung steht, eine Nachbearbeitungseinrichtung (4), die mit der Vakuum-Transportkammer über einen fünften hermetischen Durchlaß (11) in Verbindung steht, und Transporteinrichtungen (17, 18, 19, 20) in der vakuum-Transportkammer, die vorgesehen sind, um die Teile zwischen den entsprechenden Einrichtungen zu transportieren, **dadurch gekennzeichnet**, daß die Nachbearbeitungseinrichtung (4) eine Heizeinrichtung umfaßt, die dazu dient, das Teil zu erhitzen und einer Plasmabehandlung simultan zur Entfernung der Abdeckung auszusetzen, so daß eine Schutzschicht gebildet wird.

6. Vorrichtung nach Anspruch 5, **dadurch gekennzeichnet**, daß die Ätzeinrichtung (2) und die weitere Ätzeinrichtung (3) jeweils eine Kühleinrichtung umfassen.

7. Vorrichtung nach Anspruch 6, **dadurch gekennzeichnet**, daß die Kühleinrichtung einen mit Flüssigstickstoff betriebenen Kühler und einen Heizer umfaßt.

8. Vorrichtung nach Anspruch 6, **dadurch gekennzeichnet**, daß die Kühleinrichtung ein Kühlaggregat und einen Heizer umfaßt.

9. Vorrichtung nach einem oder mehreren der Ansprüche 5 bis 8, **dadurch gekennzeichnet**, daß sie weiterhin eine Parkeinrichtung (27) in der vakuum-Transportkammer (6) umfaßt, in welcher die zu ätzenden Teile während des Transports zwischen den Einrichtungen geparkt werden können.

## Revendications

1. Un procédé de gravure en continu comprenant les étapes consistant à:
former une membrane de résist multicouche sur un élément à graver;
modéliser la couche de résist supérieure au moyen de, par exemple, la lumière, les rayons-X ou un tracé de lignes électroniques;
acheminer l'élément à une première zone de traitement (2);
introduire un gaz dans la première zone de traitement et générer un plasma de décharge;
graver à sec le résist multicouche;
acheminer l'élément à une deuxième région de traitement (3);
graver à sec l'élément selon une profondeur prédéterminée dans la deuxième zone de traitement;
acheminer l'élément à une troisième région de traitement (4);
retirer le résist selon la modélisation et le traitement au plasma dans la troisième région de traitement; et
acheminer l'élément entre les régions de traitement (2,3,4) dans un environ sous dépression (6), caractérisé par:
le traitement à la chaleur de l'élément simultanément avec le retrait du résist dans la troisième région de traitement et le traitement au plasma de l'élément de façon à former une couverture protectrice.

2. Un procédé selon la revendication 1, dans lequel l'élément à graver se compose d'une pluralité de couches et lorsque les couches respectives ne peuvent pas être gravées dans le même environnement gazeux, chaque étape de gravure est réalisée dans une région de traitement individuelle.

3. Un procédé selon la revendication 2, dans lequel les environnements gazeux respectifs des régions de traitement individuelles sont fluorés et chlorés.

4. Un procédé selon la revendication 1, dans lequel le gaz de réaction pour générer la couverture protectrice est à base d'hydrocarbures.

5. Appareil de gravure en continu comprenant une chambre d'acheminement sous vide (6), une unité de charge (1) apte à communiquer avec la chambre d'acheminement sous vide par l'intermédiaire d'une première porte étanche à l'air (7), une unité de décharge (5) apte à communiquer avec la chambre d'acheminement sous vide par l'intermédiaire d'une seconde porte étanche à l'air (8), une unité de gravure de résist (2) apte à communiquer avec la chambre d'acheminement sous vide par l'intermédiaire d'une troisième porte étanche à l'air (9) et une unité de gravure supplémentaire (3) apte à communiquer avec la chambre d'acheminement sous vide par l'intermédiaire d'une quatrième porte étanche à l'air (10), une unité de post-traitement (4) apte à communiquer avec la chambre d'acheminement sous vide par l'intermédiaire d'une cinquième porte étanche à l'air (11), et des moyens d'acheminement (17, 18, 19, 20) dans la chambre d'acheminement sous vide agencés pour acheminer les articles entre les unités respectives, caractérisé en ce que l'unité de post-traitement (4) comprend un moyen de chauffage, l'unité étant apte à être actionnée pour chauffer et traiter au plasma l'élément simultanément avec le retrait du résist de façon à former une couverture protectrice.

6. Appareil selon la revendication 5, dans lequel l'unité de gravure de résist (2) et l'unité de gravure supplémentaire (3) comportent chacune des moyens de refroidissement.

7. Appareil selon la revendication 6, dans lequel les moyens de refroidissement comprennent un dispositif de refroidissement à base d'azote liquéfié et un dispositif de chauffage.

8. Appareil selon la revendication 6, dans lequel le moyen de refroidissement comprend un réfrigérateur et un dispositif de chauffage.

9. Appareil selon l'une quelconque des revendications 5 à 8, comprenant, en outre une unité d'attente (27) dans la chambre d'acheminement sous vide (6) dans laquelle les éléments à graver peuvent être mis queue à queue pendant l'acheminement entre les unités.
